Europäisches Patentamt

European Patent Office

Office européen des brevets

(11) Veröffentlichungsnummer: **0 119 529 B1**

(12) **EUROPÄISCHE PATENTSCHRIFT**

(45) Veröffentlichungstag der Patentschrift: 29.05.91

(51) Int. Cl.⁵: **H04B 14/04**

(21) Anmeldenummer: 84102267.6

(22) Anmeldetag: 02.03.84

(54) **Verfahren zum interpolativen A/D-Umsetzen.**

(30) Priorität: 22.03.83 DE 3310310

(43) Veröffentlichungstag der Anmeldung:
26.09.84 Patentblatt 84/39

(45) Bekanntmachung des Hinweises auf die
Patenterteilung:
29.05.91 Patentblatt 91/22

(84) Benannte Vertragsstaaten:
BE DE FR GB IT NL SE

(56) Entgegenhaltungen:
GB-A- 1 058 742

IEEE TRANSACTIONS ON COMMUNICA-
TIONS, Band COM-24, November 1976, Seiten
1268-1275, New York, US; J.C. CANDY et al.:
"Using triangularly weighted interpolation to
get 13-bit PCM from a sigma-delta modulator"

(73) Patentinhaber: ANT Nachrichtentechnik GmbH
Gerberstrasse 33
W-7150 Backnang(DE)

(72) Erfinder: Weidenbruch, Hans Ulrich, Dipl.-Ing.
Postdamm 12
W-3002 Wedemark 1 Ortsteil Mellendorf(DE)
Erfinder: Musmann, Hans Georg, Prof. Dr.-Ing.
Heckenrosenweg 24
W-3320 Salzgitter-Bad(DE)

(74) Vertreter: Wiechmann, Manfred, Dipl.-Ing.
ANT Nachrichtentechnik GmbH Gerberstrasse 33 Postfach 11 20
W-7150 Backnang(DE)

EP 0 119 529 B1

**Beschreibung**

Die Erfindung betrifft ein Verfahren zum interpolativen Umsetzen von Analog- in Digitalsignale, bei dem das analoge Eingangssignal mit einer Vielfachen der Nyquist-Frequenz abgetastet und entsprechend einem bit quantisisiert, dieses quantisierte Signal zum Eingang zurückgeführt und vom analogen Eingangssignal subtrahiert wird, wobei das abgetastete und quantisierte Signal durch digitale Tiefpassfilterung und anschließende Abtastung mit der Nyquist-Frequenz in ein PCM-Signal umgewandelt wird.

Ein solches Verfahren ist beschrieben in Candy, J.C. "A Use of Limit Cycle Oscillations to Obtain Robust Analog-to-Digital-Converters", IEEE Trans. Commun., vol. COM-22 (1974) pp. 298 - 305 und in

Candy, J.C., Ching, Y.C., Alexander, D.S. "Using Triangular Weighted Interpolation to get 13-bit PCM from a Sigma-Delta-Modulator" IEEE Trans. Commun., vol. COM-24 (1976) pp. 1268 1275.

Zur Digitalisierung hochwertiger Tonsignale werden Analog-Digital-Umsetzer mit einer Amplitudenauflösung entsprechend 16 bit je Abtastwert und einer Abtastrate von 48 kHz eingesetzt. Herkömmliche AD-Umsetzer erreichen diese Amplitudenauflösung durch Verwendung von Bauelementen hoher Genauigkeit. Sie sind zur Integration eines PCM-Coders für Tonsignale nicht geeignet. Interpolative AD-Umsetzer erreichen eine hohe Amplitudenauflösung nicht durch hohe Genauigkeiten der eingesetzten Bauelemente, sondern durch Abtastung mit einem Vielfachen der Nyquistfrequenz und anschließender Interpolation der grob quantisierten Abtastwerte.

In der GB-PS 10 58 742 vom 15.02.1967 ist ein interpolativer Analog-Digital-Wandler beschrieben, in dem der Komparator im Quantisierer durch den Bereich negativen Widerstandes einer Tunneldiode realisiert wird. Dies dient lediglich der Erhöhung der Schaltgeschwindigkeit bei der Umsetzung. Über die Auswirkungen dieser Maßnahme auf das Signal-Rauschverhalten ist nichts ausgesagt.

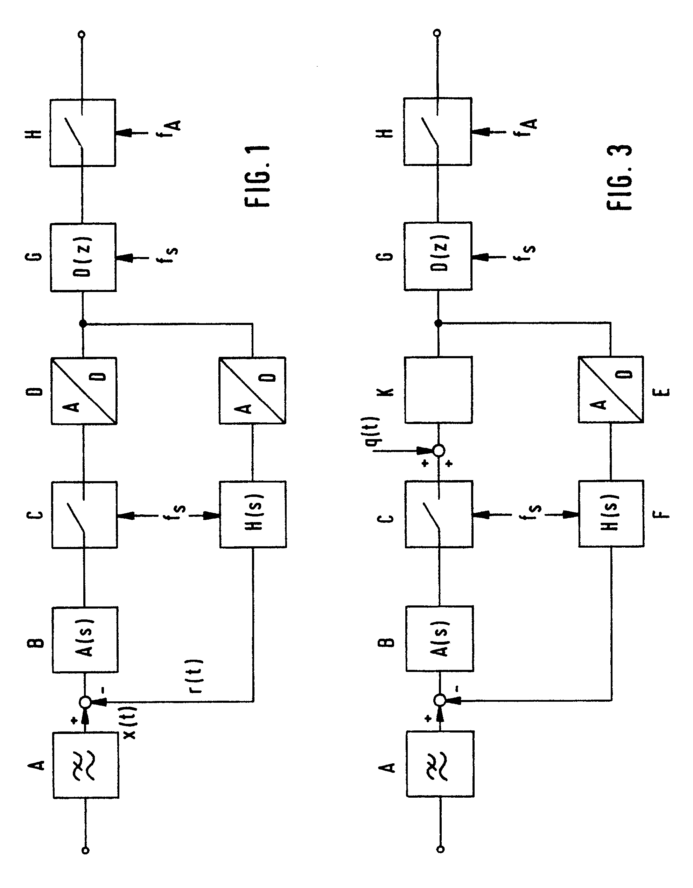

Fig. 1 zeigt die Struktur eines interpolativen AD-Umsetzers für Tonsignale nach dem Stand der Technik.

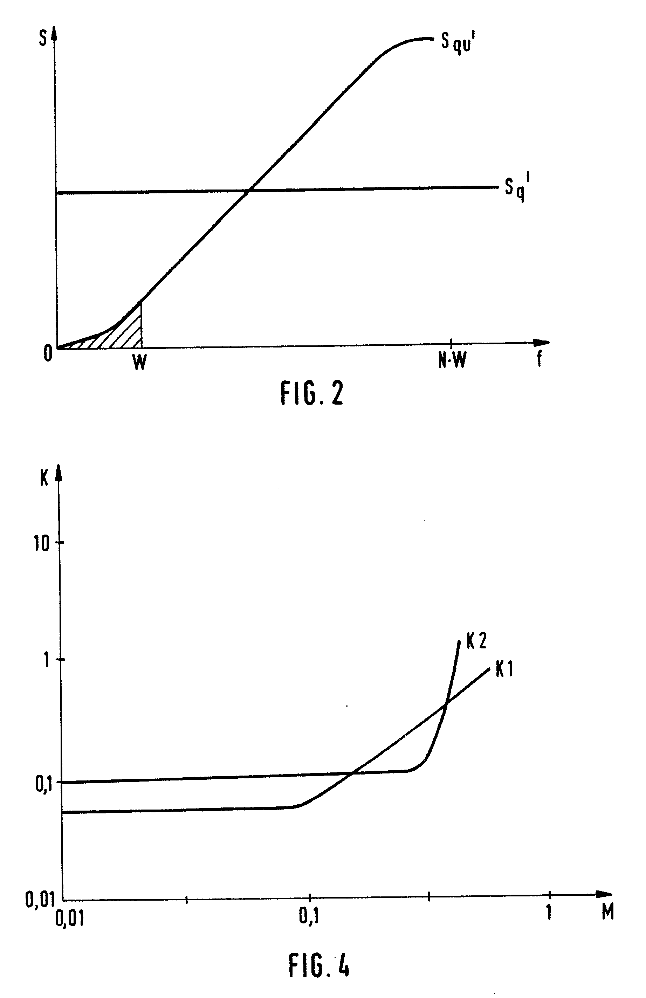

Das analoge Eingangssignal wird zunächst in einem Tiefpaßfilter A bandbegrenzt. Die Differenz zwischen dem Ausgangssignal x(t) des Tiefpaßfilters und dem rückgeführten Signal r(t) wird in einem integrierenden Netzwerk B integriert, mit einem Vielfachen der Nyquistfrequenz ZW in dem Abtaster C abgetastet und in einem AD-Umsetzer D mit geringer Amplitudenauflösung grob quantisiert. Das Ausgangssignal des AD-Umsetzers wird über einen DA-Umsetzer E und eine Halteschaltung F zum Eingang des integrierenden Netzwerkes rückgeführt. Das Leistungsdichtespektrum $S'_q$ des Quantisierungsfehler q' wird vereinfachend zunächst als einem weißen Rauschen entsprechend angenommen. Durch die Rückführung des quantisierten Signals über das integrierende Netzwerk B wird, wie in Fig. 2 dargestellt ist, der Fehleranteil im Bereich niedriger Frequenzen verringert, während er bei hohen Frequenzen angehoben wird. Die spektrale Zusammensetzung des Eingangssignals wird durch diese Rückführung nicht verändert. Durch ein digitales Tiefpaßfilter G der Bandbreite fg kann nun der hochfrequente Anteil des Quantisierungsfehlers aus dem Signal entfernt werden, so daß durch eine anschließende Unterabtastung durch den Abtaster H ein Signal mit niedriger Abtastrate aber reduzierten Quantisierungsfehler erzeugt wird. Da das Eingangssignal erst am Ausgang des interpolativen AD-Umsetzers mit der Nyquistrate abgetastet wird, kann das analoge Kanalfilter am Eingang entfallen. Die notwendige Bandbegrenzung auf die halbe Abtastfrequenz erfolgt durch das digitale Filter G. Da das Digitalfilter und der Analogteil des Umsetzers abgleichfrei sind und keine Präzisionsbauelemente enthalten, erscheint das Verfahren der interpolativen AD-Umsetzung für die Herstellung eines PCM-Coders für die Tonsignale als integrierte Schaltung geeignet.

Eine besonders günstige Realisierung der in Fig. 1 dargestellten Struktur erhält man, wenn das Signal u' (nτ) nur mit einer Amplitudenauflösung entsprechend 1 bit quantisiert wird. Der Analogteil einer solchen Struktur kann optimiert und der Umsetzungsfehler berechnet werden. Von den Ergebnissen soll hier ausgegangen werden.

Zur Beschreibung der Struktur nach Fig. 1 führt man eine Blockschaltbildänderung durch und ersetzt den 1-bit AD-Umsetzer durch einen linearen Verstärker K und eine Additionsstelle für ein Fehlersignal q (t) (Fig. 3). Für das Ausgangssignal u' (nτ) des 1-bit AD-Umsetzers D gilt dann im Spektralbereich

$$U(j\omega) = \frac{A(j\omega) \cdot G}{1 + A(j\omega) \cdot G \cdot H(j\omega)} \cdot Y(j\omega) + \frac{G}{1 + A(j\omega) \ G \ H(j\omega)} \cdot Q(j\omega) \quad (1)$$

Mit $A(j\omega) \cdot G \gg 1$ und $H(j\omega) = 1$ für $\omega < 2\pi W$ gilt

2

$$U(j\omega) = X(j\omega) + \frac{G}{1 + A(j\omega) \cdot G \cdot H(j\omega)} \cdot Q(j\omega) \qquad (2)$$

Aus (2) erkennt man, daß das Eingangssignal x(t) in seiner spektralen Zusammensetzung nicht verändert wird, während die Leistungsdichte $S'_{qu}$ des in u'(n$\tau$) enthaltenen Fehlersignals, sich entsprechend der Funktion

$$S'_{qu}(f) = \frac{G^2}{|1 + A(j2\pi f) \cdot G \cdot H(j2\pi f)|^2} \cdot S'_q(f) \qquad (3)$$

ergibt. Mit einem idealen Tiefpassfilter G der Grenzfrequenz fg berechnet sich der verbleibende Restfehler des interpolativen AD-Umsetzers unter den o.g. Annahmen zu

$$P_q = \int_{-f_g}^{f_g} \frac{1}{|A(j2\ f)|^2} \cdot S'_q(f)\ df \quad , \quad f_g = 20\ kHz \qquad (4)$$

Bei den Repräsentativpegeln +U und -U des 1-bit DA-Umsetzers kann der interpolative AD-Umsetzer mit einer Sinusschwingung der maximalen Amplitude U ausgesteuert werden. Mit dem Aussteuerungsgrad M (0 ≤ M ≤ 1) des Umsetzers ergibt sich die Leistung eines sinusförmigen Eingangssignals zu

$$P_x = M^2 \cdot \frac{U^2}{2} \qquad (5)$$

Das Signal-Rauschverhältnis des interpolativen AD-Umsetzers berechnet sich dann zu

$$\frac{P_x}{P_q} = \frac{M^2 \cdot U^2}{2 \cdot \int_{-f_g}^{f_g} \frac{1}{|A(j2\ f)|^2} \cdot S'_q(f) \cdot df} \qquad (6)$$

Durch eine Optimierung der Übertragungsfunktion des integrierenden Netzwerkes B kann der verbleibende Umsetzungsfehler minimiert werden. Die bisher gemachte Annahme, daß der Quantisierungsfehler des 1 bit Quantisierers ein weisses Leistungsdichtespektrum aufweist, kann bei einer exakten Analyse des Umsetzungsfehlers nicht mehr gelten. Es zeigt sich vielmehr, daß die spektrale Leistungsdichte des Quantisierungsfehlers abhängig von der Aussteuerung des interpolativen Umsetzers und von der Dimensionierung des integrierenden Netzwerks B ist und daß mit abnehmender Aus-steuerung der Umsetzungsfehler verkleinert wird. Der Umsetzungsfehler kann aus dem Wert, der sich bei Annahme eines weißen Leistungsdichtespektrums ergeben würde, durch einen Korrekturfaktor k(M) berechnet werden. Bei Verwendung eines einfachen Integrierers

$$A(j\omega) = \frac{1}{j\omega} \qquad (7)$$

ergibt sich unter Berücksichtigung eines nicht weißen Leistungsdichtespektrums $S'_q$ ein Signal-Rauschabstand von

3

$$\frac{P_x}{P_q} = M^2 \cdot \frac{9 \cdot N^3 \cdot \alpha^3}{2 \cdot \eta^2} \cdot \frac{1}{k_1(M)} \qquad (8)$$

$$\mathrm{mit}\ \alpha = \frac{W}{f_g}$$

Hierbei ist $k_1(M)$ der von der Aussteuerung M des interpolativen AD-Umsetzers abhängige Korrekturfaktor, dessen Verlauf in Fig. 4 dargestellt ist. Der Signal-Rauschabstand kann verbessert werden, wenn statt eines einfachen Integrierers ein zweifach integrierendes Netzwerk

$$A(j\omega) = \frac{(1 + j\omega\zeta_3)}{(1 + j\omega\tau_1)\cdot(1 + j\omega\tau_2)} \qquad (9)$$

verwendet wird. Der Signal-Rauschabstand berechnet sich nun zu

$$\frac{P_x}{P_q} = \frac{6 \cdot N^3 \cdot \alpha^3 \cdot \beta^2 \cdot \rho^2}{\psi^2 \cdot \left[(1 - \frac{4\pi^2}{3} \cdot \beta^2\ (1+\rho^2) + \frac{16}{5} \cdot \pi^4 \cdot \beta^4 \cdot \rho^2\right]} \cdot M^2 \cdot \frac{1}{k_2(M)} \qquad (10)$$

$$\mathrm{mit}\ \alpha = \frac{W}{f_g},\ \beta = \tau_1 \cdot f_g,\quad = \frac{\tau_2}{\tau_1},\ \psi = \frac{\tau_3}{\tau_1}$$

Um die angestrebte Amplitudenauflösung des interpolaven AD-Umsetzers entsprechend 16 bit zu erreichen, ist nach (10) eine interne Taktfrequenz der Interpolationsschleife von etwa 12 MHz entsprechend einem Faktor $N = 256$ notwendig. Eine meßtechnische Überprüfung an einem Labormodell erbrachte nicht die erwarteten Egebnisse. Bei einer Abtastfrequenz von 48 kHz konnte nur ein Signal-Rauschabstand von 70 dB erreicht werden. Dieser gegenüber dem ermittelten Wert erhöhte Umsetzungsfehler kann also nur auf die nicht idealen Eigenschaften der verwendeten Bauelemente zurückgeführt werden. Der Einfluß der Eigenschaften realer Bauelemente auf den Umsetzungsfehler soll im folgenden untersucht werden.

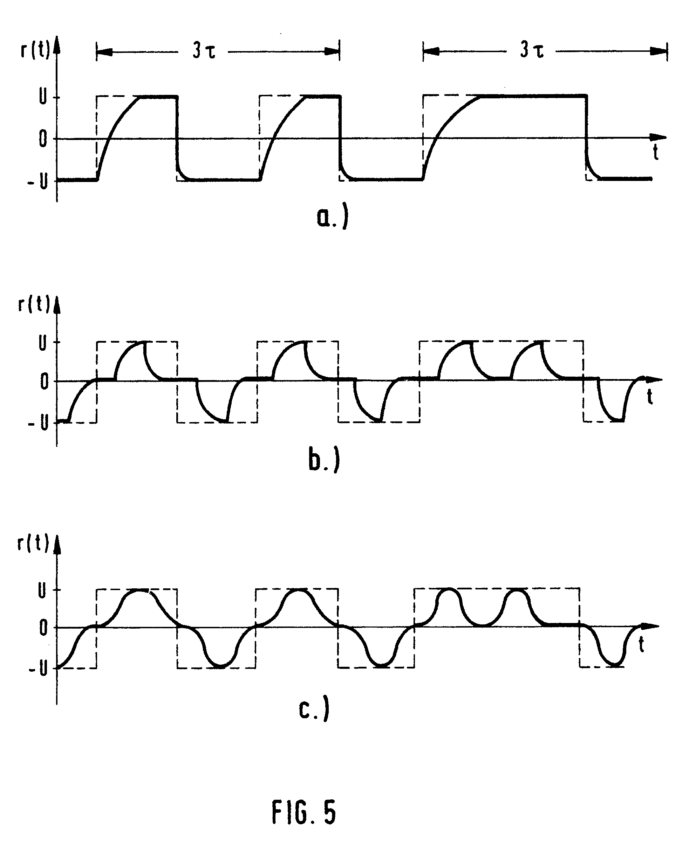

Bei den bisherigen Betrachtungen zur interpolativen AD-Umsetzung wurde gemäß Fig. 1 davon ausgegangen, daß die Abtastfolge u'(n$\tau$) durch den DA-Umsetzer E und die Halteschaltung F im Rückkopplungszweig in ein exakt mäanderförmiges Signal r(t) umgesetzt wird. Ein derartiges Signal ist schaltungstechnisch nicht realisierbar. Die Abweichungen des tatsächlichen Signalverlaufs r(t) von der idealen Mäanderform, wie sie in Fig. 5a angedeutet sind, lassen sich auf lineare und nichtlineare Verzerrungen der Halteschaltung F zurückführen.

Die von der Halteschaltung F hervorgerufenen linearen Verzerrungen können im wesentlichen als Abweichungen vom optimierten Übertragungsverhalten des integrierenden Netzwerks B interpretiert werden. Sie lassen sich durch entsprechende Korrektur von B kompensieren.

Die nichtlinearen Verzerrungen können wie folgt verursacht werden:

- Unsymmetrien im Schaltverhalten des Halteglieds bewirken, daß das Integral über zwei aufeinanderfolgende Impulse gleicher Polarität verschieden ist vom Integral zweier Einzelimpulse.
- Zeitliche Änderungen der Länge der Schleifentaktperiode $\tau$ (Taktjitter) bewirken einen Amplitudenfehler des umgesetzten PCM-Signals.
- Eigenrauschen der verwendeten analogen Bauelemente verringert den Signal-Rauschabstand des Umsetzers.

Durch Messungen konnte sichergestellt werden, daß das Eigenrauschen zu vernachlässigen ist und nur die beiden ersten Ursachen zu untersuchen sind.

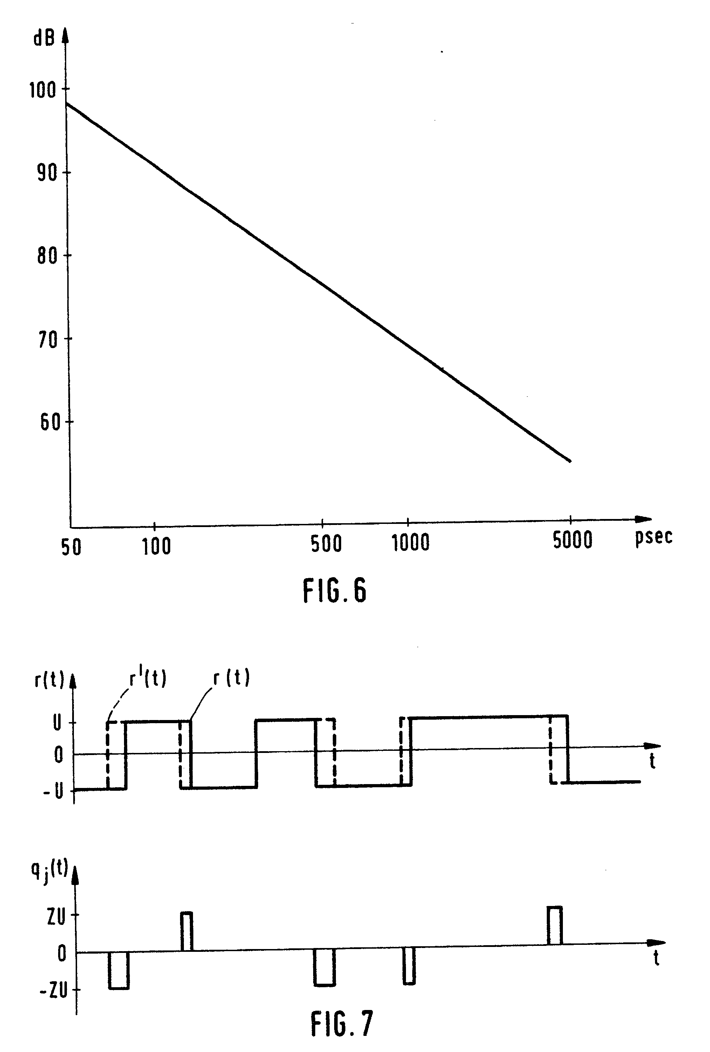

Die durch Unsymmetrien im Schaltverhalten der Halteschaltung hervorgerufenen nichtlinearen Verzerrungen bewirken eine Verringerung des Intermodulationsabstandes der Halteschaltung. Von der Halteschaltung müssen neben der Signalleistung hochfrequente Quantisierungsfehleranteile verarbeitet werden, deren Leistung selbst bei Vollaussteuerung größer ist als die Signalleistung. Ein zusätzlicher Fehleranteil im Signalfrequenzbereich O<f<W entsteht daher als Intermodulationsprodukt des in u'(n$\tau$) enthaltenen hochfrequenten Quantisierungsfehlers. Um den Einfluß dieser Unsymmterien zu untersuchen und um Optimierungsansätze zu überprüfen, wurde das Verfahren der interpolativen AD-Umsetzung auf einem Digitalrechner simuliert. Bei dieser Simulation wurde ein sinusförmiges Eingangssignalenganommen und in Abhängigkeit vom Schaltverhalten der Signal-Rauschabstand des Umsetzers kontrolliert. Das Schaltverhalten wurde hierbei zunächst durch unterschiedliche Anstiegs- und Abfallzeiten des Signals r(t) in Fig. 1 bestimmt. In Fig. 6 ist der Einfluß der Differenz $\delta$ zwischen Anstiegszeit und Abfallzeit des Signals r(t) auf den Signal-Rauschabstand des Umsetzers dargestellt. Um den erforderlichen Signal-Rauschabstand von 98 dB zu erreichen, darf nach Fig. 6 die Differenz zwischen Anstiegs-und Abfallzeit von r(t) den Wert von 50 ps nicht überschreiten.

Zeitliche Änderungen der Schleifentaktperiode $\tau$, die durch thermisches Rauschen der aktiven Baulemente in der Taktaufbereitung oder in der Halteschaltung entstehen können, bewirken einen zusätzlichen Fehler der interpolativen Analog-Digital-Umsetzung. Um diesen zusätzlichen Umsetzungsfehler quantitativ zu bestimmen, kann man gemäß Fig. 7 das Signal r(t) in ein exakt mäanderförmiges Signal r'(t) und ein impulsförmiges Fehlersignal $q_j(t)$ auflösen.

$$r(t) = r'(t) + q_j(t) \quad (11)$$

Gleichung (2) ändert sich dann zu

$$U(j\omega) = X(j\omega) + \frac{A(j\omega) \cdot G}{1 + A(j\omega) \cdot G \cdot H(j\omega)} \cdot Q_j(j\omega)$$
$$+ \frac{G}{1 + A(j\omega) \cdot G \cdot H(j\omega)} \cdot Q(j\omega) \quad (12)$$

wobei $Q(j\omega)$ den systembedingten und $Q_j(j\omega)$ den realisierungsbedingten Fehler darstellt.

Es sei $a\lambda$ eine Zufallsvariable, die den Wert +1 oder -1 annehmen kann. Nimmt man an, daß die Taktperiode eine GaußVerteilungmit dem Mittelwert $\tau$ und der Standardabweichung $\sigma$ aufweist, kann $q_j(t)$ durch eine Folge von Dirac-Stößen des Integrals $2 U \cdot \sigma$ angenähert werden.

$$q_j(t) = 2 \cdot U \cdot \sigma \sum_{\lambda = -\infty}^{\infty} a_\lambda \cdot \delta(t - \lambda\tau) \quad (13)$$

Nach der Fouriertransformation von (13) kann man das Leistungsdichtespektrum des Fehlersignals

$$S_{qj}(f) = \frac{4 \cdot U^2 \cdot \sigma^2}{\tau} \quad (14)$$

und die Fehlerleistung im Basisband berechnen.

$$P_{qj} = \int_{-fg}^{fg} \frac{4 \cdot U^2 \cdot \sigma^2}{\tau} \, df = 8 \cdot U^2 \cdot \sigma^2 \cdot \frac{fg}{\tau} \quad ; fg = 20 \text{ kHz} \quad (15)$$

Damit der durch die zeitlichen Änderungen der Taktperiode $\tau$ bewirkte zusätzliche Umsetzungsfehler zu vernachlässigen ist, muß die Bedingung

$$\frac{P_x}{P_{qj}} = \frac{M^2}{16 \cdot \delta^2} \cdot \frac{\tau}{f_g} \gg \frac{P_x}{P_q} \tag{16}$$

erfüllt sein. Für die Standardabweichung der Taktperiode $\tau$ ergibt sich ein Maximalwert

$$\delta \ll \frac{M}{4} \cdot \sqrt{\frac{P_q}{P_x} \cdot \frac{\tau}{f_g}} \quad ; \quad \tau = \frac{1}{2NW} \tag{17}$$

der bei einem angestrebten Signal-Rauschabstand von 98 dB den Wert von 6,2 ps nicht überschreiten darf. Dieser theoretisch ermittelte Wert konnte durch die vorher beschriebene Simulation der interpolativen AD-Umsetzung auf einem Digitalrechner bestätigt werden. Das Schaltverhalten wurde dabei durch die Darstellung der Schleifentaktperiode $\tau$ als Zufallsvariable mit einer Wahrscheinlichkeitsdichtenach Gauß bestimmt.

Eine Darstellung des Signals r(t) durch mäanderförmige Impulse mit diesem geringen Jitter ist mit vertretbarem Aufwand nicht zu erreichen. Das verfahren der interpolativen AD-Umsetzung wurde daher im Hinblick auf eine Verminderung der durch die Realisierung bedingten Fehler modifiziert.

Es wurde also festgestellt, daß mit einer Schaltungsstruktur nach dem Stand der Technik die Genauigkeitsanforderungen bezüglich des Signal-Rauschabstandes, wie sie in der heutigen Tonstudiotechnik gefordert werden, nicht erreichbar sind.

Die Aufgabe der vorliegenden Erfindung besteht daher darin, das Verfahren nach dem Oberbegriff des Anspruches 1 so zu verbessern, daß die genannten Forderungen eingehalten werden.

Diese Aufgabe wird dadurch gelöst, daß entweder die Differenz zwischen analogem Eingangssignal und rückgeführtem Signal oder das rückgeführte Signal oder das analoge und das rückgeführte Signal integriert werden, wobei das rückgeführte Signal durch Zusammentsetzung von Einzelimpulsen dargestellt wird, die jeweils innerhalb eines Taktintervalls wieder auf einen Mittelwert zurückkehren so daß Verzerrungen vermieden werden, die auftreten, wenn das Integral über zwei aufeinanderfolgende Impulse gleicher Polarität verschieden ist vom Integral zweier Einzelimpulse.

Vorteilhafte Weiterbildungen der Erfindung werden dadurch erreicht, daß die genannten Impulse rechteckförmig, sinusförmig, trapezförmig oder dreieckförmig sind.

Anhand weiterer Figuren wird die Erfindung beschrieben.

Um den Signal-Rauschabstand eines interpolativen AD-Umsetzers für Tonsignale zu verbessern, muß also nach der Erfindung mindestens einer der folgenden Schritte erfolgen:

- Zur Vermeidung der durch Unsymmetrien im Schaltverhalten der Halteschaltung bewirkten Verzerrungen müssen für die Darstellung des analogen Signals r(t) Impulsformen verwendet werden, die gemäß Fig. 5b innerhalb einer Taktperiode wieder auf den Mittelwert O der beiden Repräsentativwerte +U und -U zurückkehren.
- Zur Begrenzung des durch Taktjitters bewirkten Umsetzungsfehlers sind für die Darstellung des analogen Signals r(t) Impulsformen zu verwenden, die mit einer hohen zeitlichen Genauigkeit erzeugt werden können.
- Um eine ausreichende Entkopplung der einzelnen Stufen des Analogteils im interpolativen AD-Umsetzer zu erreichen, sind höchstfrequente Anteile im Signal r(t) durch Verwendung von Impulsformen mit geringer Flankensteilheit zu vermeiden.

In Fig. 5c wird gezeigt, wie das Signal r(t) aus sinusförmigen Einzelimpulsen zusammengesetzt wird, die mit einer größeren spektralen Reinheit erzeugt werden können.

In Fig. 8 wird die Anordnung eines interpolativen AD-Umsetzers gezeigt, die zum Durchführen des erfindungsgemäßen Verfahrens dient. Sie wurde abgeleitet aus der Anordnung nach Fig. 1 für die Verwendung sinusförmiger Impulse zur Darstellung des Signals r(t).

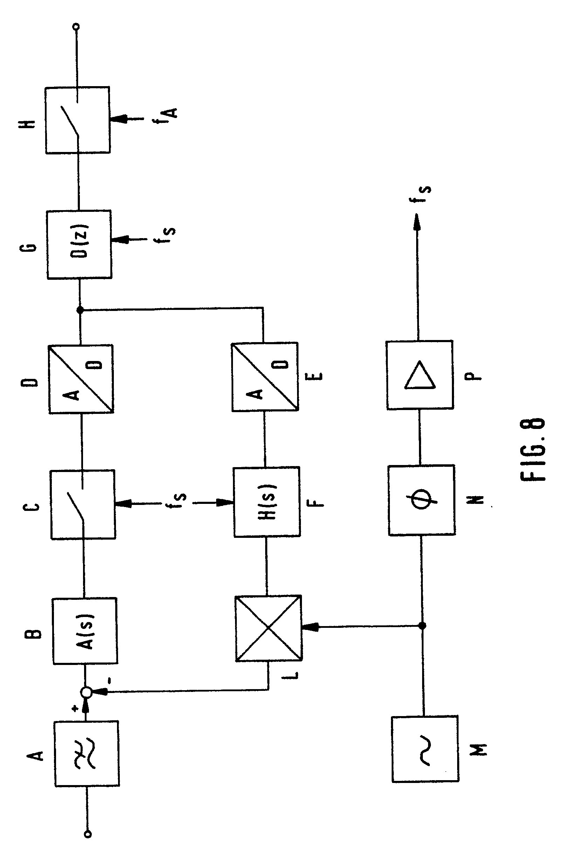

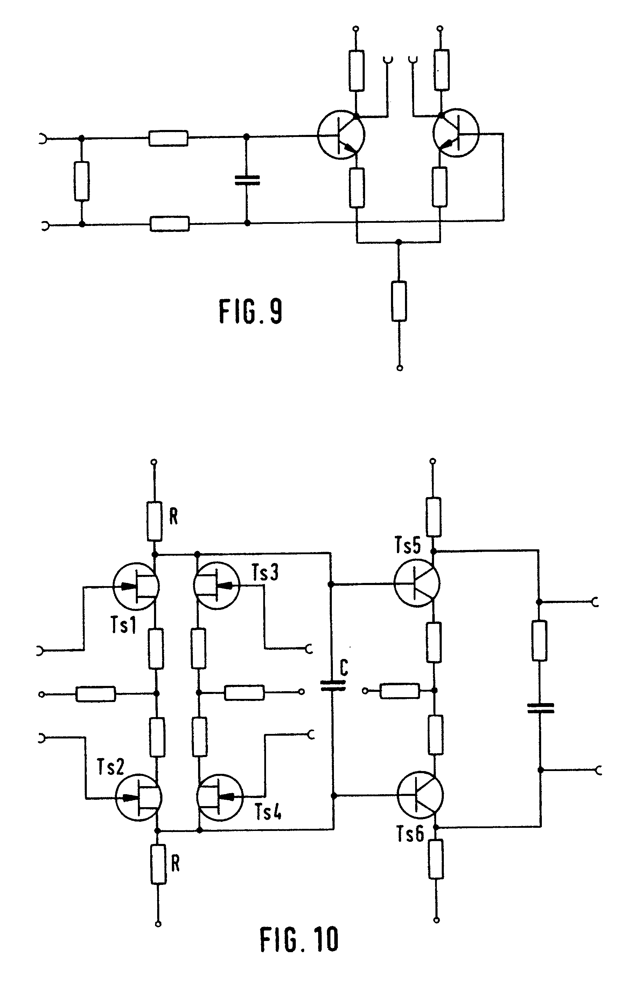

Die Wirkungsweise des Verfahrens nach der Erfindung wird dargestellt an dem Beispiel einer Schaltung, die nach Fig. 8 praktisch ausgeführt wurde. Das analoge Eingangssignal wird zunächst in einem Tiefpaßfilter A bandbegrenzt. Ein Ausführungsbeispiel eines solchen Tiefpaßfilters wird in Fig. 9 dargestellt und beschrieben in dem Buch von U. Tietze, Ch. Schenk: Halbleiterschaltungstechnik, 5. Auflage, Berlin, Heidelberg, New York, 1980, S. 59ff. Die Differenz zwischen dem Ausgangssignal x(t) des Tiefpaßfilters A und dem rückgeführten Signal r(t) wird in dem integrierenden Netzwerk B integriert. Diese Differenzbildung und die Integration wird bewirkt in einem Netzwerk, wie es in Fig. 10 gezeigt wird. Die Transistoren Ts1 und Ts2 bzw. Ts3 und Ts4 sind in einem Ausführungsbeispiel der Schaltung Doppeltransistoren vom Typ U431 der Firma Siliconix Inc., Santa Clara, Calif., USA. Sie sind Bestandteileder Schaltung zur Differenzbildung, während die Transistoren Ts5 und Ts6, beide vom Typ MD7003 der Firma Motorola, einen Trennverstärker für das integrierende Netzwerk R, C darstellen.

Nach der Integration im Netzwerk B wird das Signal mit einem Vielfachen der Nyquistfrequenz ZW in dem Abtaster C abgetastet und in dem AD-Umsetzer D mit geringer Amplitudenauflösung grob quantisiert. Das geschieht mit Hilfe einer integrierten Schaltung mit der Bezeichnung SP9685 der Firma Plessey Inc., Melville, N.Y., USA.

Das Ausgangssignal des AD-Umsetzers D wird über den DA-Umsetzer E und die Halteschaltung F, die aus der integrierten Schaltung mit der Bezeichnung SP1670 der Firma Plessey Inc., Melville, N.Y., USA aufgebaut ist.

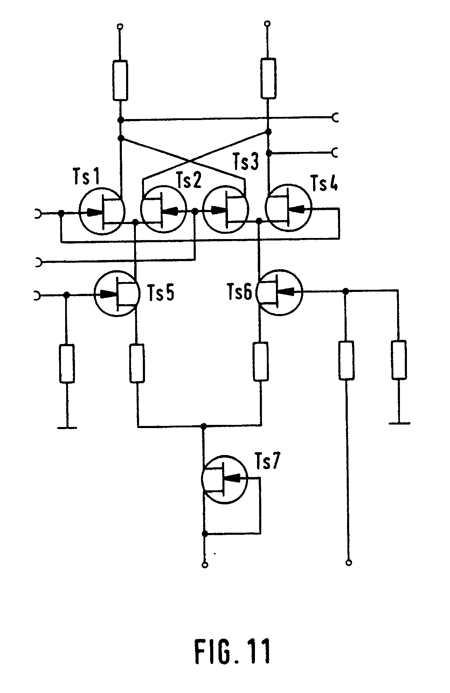

Von der Halteschaltung F wird das Signal weitergegeben an die Multiplizierschaltung L, die wie in Fig. 11 aufgebaut ist, wobei die Transistoren Ts1 und Ts4 aus einem Vierfachtransistor mit der Typenbezeichnung U350, die Transistoren Ts5 und Ts6 aus einem Doppeltransistor mit der Typenbezeichnung U431 und der Transistor Ts7 (Konstantstromquelle) aus einem Einfachtransistor mit der Typenbezeichnung U310 bestehen. Alle diese Transistortypen sind Erzeugnisse der Firma Siliconix Inc., Santa Clara, Calif., USA.

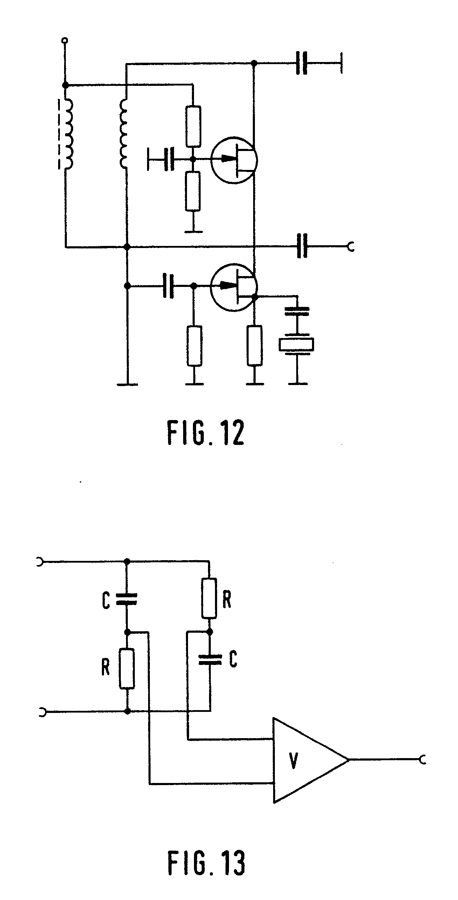

Der Quarz-Oszillator M ist aufgebaut wie in Fig. 12 gezeigt. Dieser Oszillator wird beschrieben in der Zeitschrift UKW-Berichte, Heft 2, 1981, Seite 92. Das Ausgangssignal der Halteschaltung F steuert also in der Multiplizierschaltung L die Polarität sinusförmiger Impulse, die aus dem Quarzoszillator M abgeleitet werden. Das Ausgangssignal des Quarzoszillators wird außerdem dazu benutzt, um über einen Phasenschieber N und einen Impulsformer P das genannte Vielfache der Nyquistfrequenz fs zu gewinnen.

Die ausgeführte Schaltung von N und P wird in Fig. 13 gezeigt. Das Netzwerk R und C dient in bekannter Weise dazu, eine Phasendrehung von $90°$ zu erzielen, während die Schaltung V, eine integrierte Schaltung mit der Typenbezeichnung SP9685 der Firma Plessey Inc., Melville, N.Y. USA, zur Impulsformung dient.

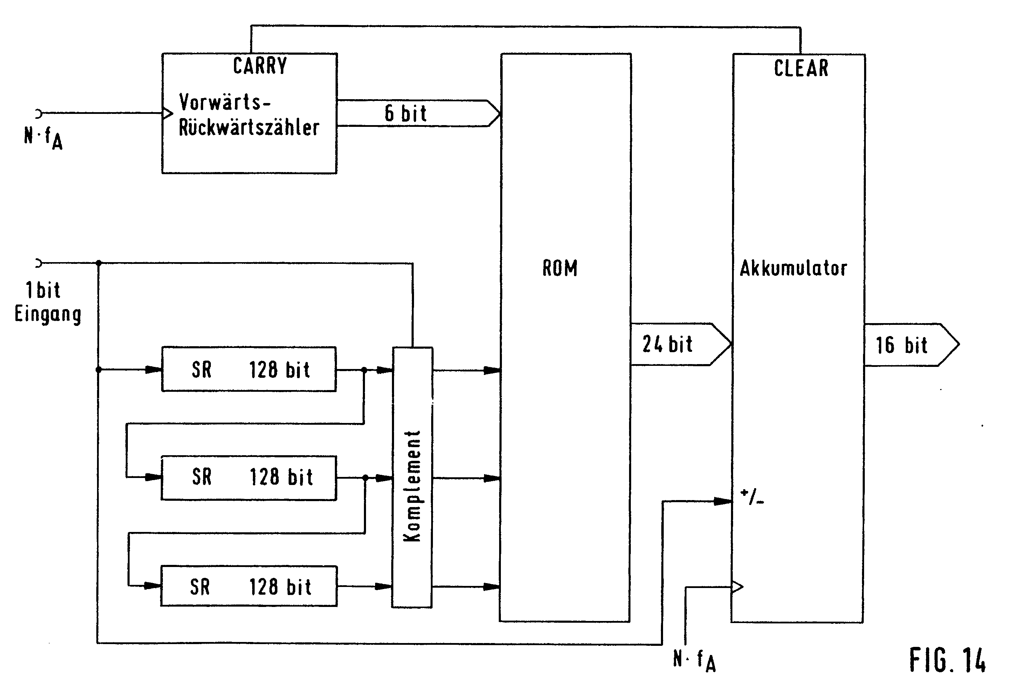

Das Ausgangssignal der Gesamtschaltung wird aufbereitet über das digitale Tiefpaßfilter G und den Abtaster H. Eine ausgeführte Schaltung wird in Fig. 14 gezeigt.

Die Frequenz $fs = N \cdot f_A$ wird über einen Vorwärts- Rückwärtszähler auf ein ROM (read-only-memory) gegeben, an dessen Eingängen das Ausgangssignal des AD-Umsetzers D über drei Schieberegister SR (128 bit) und eine Komplementschaltung geführt ist. Das Ausgangssignal des ROM wird über den Akkumulator weiterverarbeitet. Als Schieberegister wurden in der realisierten Schaltung integrierte Schaltungen der Firma TRW Semiconductors Inc., Lawndale, Calif., USA mit der Typenbezeichnung TDC1005 eingesetzt. Das ROM wurde aufgebaut aus 3 Stück Schaltungen mit der Typenbezeichnung 7641 der Firma Harris Corp., Cleveland, Ohio, USA und der Akkumulator bestand aus 8 der integrierten Schaltungen der Typenbezeichnung SN74 S281 der Firma Texas Instruments Inc., Dallas, Texas, USA.

Ein nach der Erfindung betriebener interpolativer AD-Umsetzer konte mit einem Signal-Rauschabstand von mehr als 85 dB (entsprechend 14 bit) bei einer Abtastrate von 50 kHz realisiert werden. Gegenüber dem Stand der Technik ergibt sich damit eine Verbesserung des Signal-Rauschabstandes um mehr als 15 dB.

## Ansprüche

1. Verfahren zum interpolativen Umsetzen von Analog- in Digitalsignale, bei dem das analoge Eingangssignal mit einer Vielfachen der Nyquist-Frequenz abgetastet und entsprechend mit einem bit quantisiert, dieses quantisierte Signal zum Eingang zurückgeführt und vom analogen Eingangssignal subtrahiert wird, wobei das abgetastete und quantisierte Signal durch digitale Tiefpaßfilterung und anschließender Abtastung mit der Nyquist-Frequenz in ein PCM-Signal umgewandelt wird, dadurch gekennzeichnet, daß entweder die Differenz zwischen analogem Eingangssignal und rückgeführtem Signal oder das rückgeführte Signal oder das analoge und das rückgeführte Signal integriert werden, wobei das rückgeführte Signal durch Zusammensetzung von Einzelimpulsen gebildet wird, die jeweils innerhalb eines Taktintervalls wieder auf einen Mittelwert zurückkehren, so daß Verzerrungen vermieden werden, die auftreten, wenn das Integral über zwei aufeinanderfolgende Impulse gleicher Polarität verschieden ist vom Integral zweier Einzelimpulse.

2. Verfahren nach Anspruch 1, dadurch gekennzeichnet, daß die Impulse rechteckförmig sind.

3. Verfahren nach Anspruch 1, dadurch gekennzeichnet, daß die Impulse sinusförmig sind.

4. Verfahren nach Anspruch 1, dadurch gekennzeichnet, daß die Impulse trapezförmig sind.

5. Verfahren nach Anspruch 1, dadurch gekennzeichnet, daß die Impulse dreieckförmig sind.


## Claims

1. Method for the interpolative translation of analog signals into digital signals, in which method the analog input signal is scanned at a multiple of the Nyquist frequency and quantised correspondingly with a bit, this quantised signal is fed back to the input and subtracted from the analog input signal, wherein the scanned and quantised signal is converted into a pulse code modulation signal by digital low-pass filtering and subsequent scanning at the Nyquist frequency, characterised thereby, that either the difference between the analog input signal and the fed-back signal or the fed-back signal or the analog input signal and the fed-back signal are integrated, wherein the fed-back signal is formed by the composition of individual pulses which each again return back to a mean value within a pulse cycle interval so that distortions are avoided, which arise when the integral over two successive pulses of like polarity is different from the integral of two individual pulses.

2. Method according to claim 1, characterised thereby, that the pulses are rectangular.

3. Method according to claim 1, characterised thereby, that the pulses are sinusoidal.

4. Method according to claim 1, characterised thereby, that the pulses are trapezoidal.

5. Method according to claim 1, characterised thereby, that the pulses are triangular.


## Revendications

1. Procédé de conversion par interpolation de signaux analogiques en signaux numériques, où le signal analogique d'entrée est échantillonné selon une fréquence multiple de la fréquence de Nyquist et quantifié sur un bit, où ce signal quantifié est renvoyé à l'entrée et soustrait du signal analogique d'entrée, où le signal échantillonné et quantifié est transformé en signal MIC par filtrage numérique passe-bas puis échantillonnage à la fréquence de Nyquist, caractérisé en ce que l'on intègre soit la différence entre le signal analogique d'entrée et le signal de réaction, soit le signal de réaction, soit le signal analogique et le signal de réaction, le signal de réaction étant obtenu par la réunion d'impulsions individuelles qui, à l'intérieur de l'intervalle d'une période d'horloge, reviennent à une valeur moyenne de manière à éviter les distorsions qui se produisent lorsque l'intégrale sur deux impulsions successives de même polarité est différente de l'intégrale de deux impulsions individuelles.

2. Procédé selon la revendication 1, caractérisé en ce que les impulsions sont de forme carrée.

3. Procédé selon la revendication 1, caractérisé en ce que les impulsions sont de forme sinusoïdale.

4. Procédé selon la revendication 1, caractérisé en ce que les impulsions sont de forme trapézoïdale.

5. Procédé selon la revendication 1, caractérisé en ce que les impulsions sont de forme triangulaire.

FIG. 1

FIG. 3

FIG. 2

FIG. 4

FIG. 5

FIG. 6

FIG. 7

FIG.8

EP 0 119 529 B1

FIG. 9

FIG. 10

FIG. 11

**FIG. 12**

**FIG. 13**

FIG. 14